# EUROPÄISCHE PATENTSCHRIFT

(11) **EP 0 718 993 B1**
(45) Veröffentlichungstag und Bekanntmachung des Hinweises auf die Patenterteilung: **14.10.1998**
(21) Anmeldenummer: 95119505.6
(22) Anmeldetag: 11.12.1995
(51) Int. Cl.: H04B 10/28, H01S 3/096

(54) **Schaltungsanordnung zur Sende-/Empfangsbetriebsumsteuerung einer im Zeitgetrenntlagebetrieb arbeitenden, alternierend als Sendediode und Emfangsdiode genutzten Laserdiode**
Emission or reception mode selection circuit for a laser diode, operating alternatively as an emitting or receiving diode
Circuit de sélection de fonctionnement en émission ou en réception d'une diode laser, fonctionnant en semi-duplex, utilisée en alternance comme diode d'émission ou de réception

(30) Priorität: 20.12.1994 DE 4445505
(43) Veröffentlichungstag der Anmeldung: 26.06.1996
(73) Patentinhaber: SIEMENS AKTIENGESELLSCHAFT, 80333 München (DE)
(72) Erfinder: Bolze, Thomas, Dr.rer.nat., D-80804 München (DE); Neidlinger, Stephan, Dr.-Ing., D-80807 München (DE); Neuhaus, Thomas, Dipl.-Ing., D-81735 München (DE); Weiske, Klaus-Jörg, Dipl.-Ing., D-82256 Fürstenfeldbruck (DE); Das, Chandan, Dr.-Ing-, D-82131 Gauting (DE); Knoblauch, Henrik, D-82061 Neuried (DE)

(56) Entgegenhaltungen:
- EP-A- 0 330 190
- EP-A- 0 586 285
- PATENT ABSTRACTS OF JAPAN vol. 007 no. 033 (E-157) ,9.Februar 1983 & JP-A-57 185740 (MATSUSHITA DENKI SANGYO KK) 16.November 1982,

## Beschreibung

Neuere Entwicklungen der Fernmeldetechnik führen in der Ebene der Teilnehmeranschlußleitungen zu passiven optischen Telekommunikationssystemen, in denen jeweils eine Mehrzahl von dezentralen Einrichtungen (Teilnehmerstellen oder jeweils eine Mehrzahl von Teilnehmerstellen zusammenfassende sogenannte Distant Units) jeweils über eine eigene Lichtwellenleiter-Anschlußleitung mit einem optischen Verzweiger verbunden ist, der direkt oder über wenigstens einen weiteren optischen Verzweiger mit einem gemeinsamen Lichtwellenleiteranschluß einer - insbesondere durch eine Vermittlungsstelle gegebenen - zentralen Einrichtung über einen Lichtwellenleiter-Bus verbunden ist (EP-A-0 171 080; ISSLS'88, Conf.Papers 9.4.1...5; BR Telecom Technol.J. 17(1989)2, 100...113).

In einem Lichtwellenleiter-Telekommunikationssystem kann der zwischen zwei Telekommunikationsstellen verlaufende Lichtwellenleiter in beiden Übertragungsrichtungen ausgenutzt werden. beispielsweise im Zeitgetrenntlagebetrieb, wobei unter Wegfall einer zusätzlichen Richtungsweiche in der jeweiligen Telekommunikationsstelle die als Sender dienende lichtemittierende Diode alternierend auch als Empfangsdiode genutzt werden kann, die in den Sendepausen die von der anderen Telekommunikationsstelle kommenden Signale empfängt (JP-A-61-89735; DE-A1-38 22 803; EP-A2-0 330 190; Zürich Seminar '86 Conf. Papers B3, 4.3 in Table 1). So kann eine Laserdiode in Durchlassrichtung gepolt als Sendediode und in Sperrrichtung gepolt als Empfangsdiode dienen (EP-A1-0 586 285).

In einem solchen Ping-Pong-Betrieb kann die optische Nachrichtenübertragung sowohl in Punkt-zu-Punkt-Verbindungen als auch in passiven optischen Netzen mit nicht zu hohen Teilnehmerzahlen (z.Zt etwa 8 bis 16) vor sich gehen. Dabei stellt sich die Aufgabe, die Transceiverschaltung, d.h. die Laserdiode mit der sie steuernden Sendeschaltung für den Sendebetrieb und mit der von ihr gesteuerten Empfangsschaltung für den Empfangsbetrieb, ohne wesentliche Einschränkung der Empfindlichkeit und der Bandbreite des Empfängers sehr schnell vom Sende- in den Empfangsbetrieb umschalten zu können, und die Erfindung zeigt hierzu einen Weg.

Die Erfindung betrifft eine Schaltungsanordnung zur Sende-/Empfangsbetriebsumsteuerung einer im Zeitgetrenntlagebetrieb arbeitenden, alternierend als Sendediode und Empfangsdiode genutzten Laserdiode; diese Schaltungsanordnung ist erfindungsgemäß dadurch gekennzeichnet, daß der von einer Arbeitspunktregelschaltung her mit einem Vorstrom und von einer Modulationsschaltung her mit dem Modulationsstrom beaufschlagten Laserdiode die Serienschaltung eines ohmschen Widerstands und einer Diode parallelgeschaltet ist, mit deren Verbindungspunkt von ohmschem Widerstand und Diode der Eingang eines empfangsseitigen Transimpedanzverstärkers kapazitiv verbunden ist; die genannte Diode ist dabei zweckmäßigerweise eine Schottky-Diode.

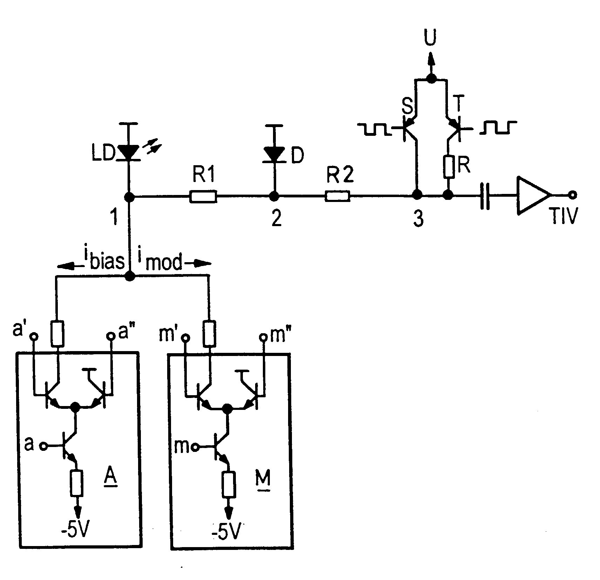

Die Erfindung schafft eine schnell vom Sende- in den Empfangsbetrieb umschaltbare Transceiverschaltung hoher Empfangsempfindlichkeit. Weitere Besonderheiten der Erfindung werden aus der nachfolgenden näheren Erläuterung eines Ausführungsbeispiels einer Schaltungsanordnung gemäß der Erfindung anhand der Zeichnung ersichtlich.

In der Zeichnung ist schematisch in einem zum Verständnis der Erfindung erforderlichen Umfang eine Schaltungsanordnung zur Sende-/Empfangsbetriebsumsteuerung einer im Zeitgetrenntlagebetrieb arbeitenden, alternierend als Sendediode und als Empfangsdiode genutzten Laserdiode LD skizziert, die von einer Arbeitspunktregelschaltung A her mit einem Vorstrom i_{bias} und von einer Modulationsschaltung M her mit einem Modulationsstrom i_{mod} beaufschlagt wird.

Die Arbeitspunktregelschaltung A kann dabei mit einem Differenzverstärker mit zwei emittergekoppelten Transistoren und einem im gemeinsamen Emitterzweig liegenden dritten Transistor gebildet sein, von dessen Steuereingang a her der Vorstrom i_{bias} regelbar ist; von zwei Eingängen a', a" her werden die beiden emittergekoppelten Transistoren zwischen dem Sendebetriebszustand und dem Empfangsbetriebszustand umgesteuert: Liegt am Eingang a' ein 1-Signal und am Eingang a" ein 0-Signal an, so fliesst durch die Arbeitspunktregelschaltung A ein Laser-Vorstrom i_{bias}, auf Grund dessen die Laserdiode sich im Sendebetriebszustand befindet; liegt umgekehrt am Eingang a' ein 0-Signal und am Eingang a" ein 1-Signal an, so fliesst durch die Arbeitspunktregelschaltung A kein solcher Laser-Vorstrom mit der Folge, dass die Laserdiode sich im Empfangsbetriebszustand befindet.
Die Modulationsschaltung M kann ebenfalls mit einem Differenzverstärker mit zwei emittergekoppelten Transistoren und einem im gemeinsamen Emitterzweig liegenden dritten Transistor gebildet sein, von dessen Steuereingang m her die Amplitude des Modulationsstroms i_{mod} regelbar ist; von zwei Eingangen m', m" her werden die beiden emittergekoppelten Transistoren mit dem Modulationssignal beaufschlagt: Im Sendebetriebszustand liegt am Eingang m' eine entsprechende Folge von 1- und O-Modulationssignalelementen und am Eingang m" die invertierte Signalelementefolge an; in den Sendepausen liegt am Eingang m' ein 0-Signal und am Eingang m" ein 1-Signal an.

Der so von der Arbeitspunktregelschaltung A her mit dem Vorstrom i_{bias} und von der Modulationsschaltung M her mit dem Modulationsstrom i_{mod} beaufschlagten Laserdiode LD parallelgeschaltet ist nun die Serienschaltung eines ohmschen Widerstands R1 und einer Diode D, vorzugsweise einer Schottky-Diode, um kurze Schaltzeiten und einen kleinen Innenwiderstand im Durchlaßbereich zu erhalten. Mit dem Verbindungspunkt 2 von ohmschem Widerstand R1 und (Schottky-)Diode D ist der Eingang eines empfangsseitigen Transimpedanzverstärkers TIV (beispielsweise des Typs NE/SA5211) kapazitiv verbunden. Dabei ist in dem in der Zeichnung skizzierten Ausführungsbeispiel der (Schottky-)Diode D die Serienschaltung eines ohmschen Widerstands R2 und eines bei Sendebetrieb leitenden Transistorschalters S parallelgeschaltet, an deren Verbindungspunkt 3 von ohmschem Widerstand R2 und Transistorschalter S der Eingang des Transimpedanzverstärkers TIV kapazitiv angeschlossen ist.

Im Sendebetrieb fällt an der Laserdiode LD (bei einer Speisespannung von im Ausführungsbeispiel - 5 V) eine mittlere Spannung von etwa - 1,5 V ab; die Modulationsamplitude beträgt am Schaltungspunkt 1 etwa ± 150 mV. Am Schaltungspunkt 2 des durch den ohmschen Widerstand R1 und die Schottky-Diode D gebildeten ersten Spannungsteilers bemisst sich der Spannungshub auf - 0,5 V; die Modulationsamplitude macht sich am Schaltungspunkt 2 mit etwa ± 20 mV bemerkbar. Eine Zerstörung des Transimpedanzverstärkers TIV wird damit verhindert. An dem kapazitiv an den Schaltungspunkt 3 des durch den ohmschen Widerstand R2 und den Transistorschalter S gebildeten zweiten Spannungsteilers angeschlossenen Eingang des Transimpedanzverstärkers TIV schliesslich treten, abgesehen von kurzen Spannungsspitzen während des Umschaltens zwischen den beiden Betriebszuständen, nur noch vernachlässigbar kleine Spannungen auf, so dass eine längere Übersteuerung des Transimpedanzverstärkers TIV vermieden und damit ein schnelles Umschalten vom Sende- in den Empfngsbetriebszustand gewährleistet wird. Zugleich bleibt die Empfangsempfindlichkeit unbeeinträchtigt, da die Diode D und der Transistor S im Empfangsbetriebszustand gesperrt sind.

Die insoweit erläuterte Schaltungsanordnung kann innerhalb von 300 ns bis 3 µs (je nach dem empfangenen Lichtpegel) vom Sende- in den Empfangsbetriebszustand umgeschaltet werden; die Empfangsbandbreite beträgt im Ausführungsbeispiel etwa 55 MHz.

Die Schaltungsanordnung kann auch ohne den Transistorschalter *S* betrieben werden, wobei die Umschaltzeit dann bei 10 µs liegt.

In der insoweit erläuterten Schaltungsanordnung arbeitet die Laserdiode LD im Empfangsbetriebszustand ohne Vorspannung. Soll an der Laserdiode im Empfangsbetriebszustand eine Sperrspannung anliegen, so kann dem dann, wie dies auch aus der Zeichnung ersichtlich ist, an einer Sperrpotentialquelle U liegenden Transistorschalter S die Serienschaltung eines gegensinnig zum Transistorschalter gesteuerten Überbrückungsschalters T und eines ohmschen Widerstands R parallelgeschaltet sein, dessen Widerstandswert mit beispielsweise 50 kΩ groß gegen den typischerweise bei 200 Ω liegenden Eingangswiderstandswert des Transimpedanzverstärkers TIV und klein gegen den Sperrwiderstandswert der Laserdiode LD ist. Im Sendebetriebszustand ist die Kollektor-Emitter-Strecke des Schaltertransistors S wiederum leitend und die Kollektor-Emitter-Strecke des Überbrückungstransistors T nichtleitend, so daß, wie im vorstehenden beschrieben, die Sendesignale am Eingang des Transimpedanzverstärkers TIV zu vernachlässigen sind. Im Empfangsbetriebszustand ist die Kollektor-Emitter-Strecke des Schaltertransistors S nichtleitend und die Kollektor-Emitter-Strecke des Überbrückungstransistors T leitend. An der Laserdiode liegt dabei praktisch die Sperrspannung (U) an, da der Widerstandswert des ohmschen Widerstands R mit beispielsweise 50 kΩ klein gegenüber dem Sperrwiderstandswert der Laserdiode LD ist; zugleich gelangen die von der Laserdiode LD empfangenen Signale unbeeinträchtigt zum Transimpedanzverstärker TIV, da dessen Eingangswiderstandswert wesentlich kleiner als derjenige des ohmschen Widerstands R ist.

## Patentansprüche

1. Schaltungsanordnung zur Sende-/Empfangsbetriebsumschaltung mit einer im Zeitgetrenntlagebetrieb arbeitenden, alternierend als Sendediode und Empfangsdiode genutzten Laserdiode (LD),
**dadurch gekennzeichnet,**
daß der von einer Arbeitspunktregelschaltung (A) her mit einem Vorstrom (i_{bias}) und von einer Modulationsschaltung (M) her mit einem Modulationsstrom (i_{mod}) beaufschlagten Laserdiode (LD) die Serienschaltung eines ohmschen Widerstands (R1) und einer Diode (D) parallelgeschaltet ist, wobei mit dem Verbindungspunkt (2) von ohmschem Widerstand (R1) und Diode (D) der Eingang eines empfangsseitigen Transimpedanzverstärkers (TIV) kapazitiv verbunden ist.

2. Schaltungsanordnung nach Anspruch 1,
**dadurch gekennzeichnet,**
daß die Diode (D) eine Schottky-Diode ist.

3. Schaltungsanordnung nach Anspruch 1 oder 2,
**dadurch gekennzeichnet,**
daß der Diode (D) die Serienschaltung eines ohmschen Widerstands (R2) und eines bei Sendebetrieb leitenden Transistorschalters (S) parallelgeschaltet ist, wobei an den Verbindungspunkt (3) von ohmschem Widerstand (R2) und Transistorschalter (S) der Eingang des Transimpedanzverstärkers (TIV) kapazitiv angeschlossen ist.

4. Schaltungsanordnung nach Anspruch 3,
**dadurch gekennzeichnet,**
daß dem an einer Sperrpotentialquelle (U) für die Laserdiode (LD) liegenden Transistorschalter (S) die Serienschaltung eines gegensinnig zum Transistorschalter gesteuerten Überbrückungsschalters (T) und eines ohmschen Widerstands (R) mit gegen den Eingangswiderstandswert des Transimpedanzverstärkers (TIV) großem und gegen den Sperrwiderstandswert der Laserdiode (LD) kleinem Widerstandswert parallelgeschaltet ist.

## Claims

1. Circuit arrangement for transmission mode/reception mode changeover with a laser diode (LD) which operates in the time division duplex mode and is alternately used as transmission diode and reception diode, characterized in that the series circuit formed by a non-reactive resistor (R1) and a diode (D) is connected in parallel with the laser diode (LD), which receives a bias current (i_{bias}) from an operating-point regulating circuit (A) and a modulation current (i_{mod}) from a modulation circuit (M), the input of a reception-end transimpedance amplifier (TIV) being capacitively connected to the junction point (2) between non-reactive resistor (R1) and diode (D).

2. Circuit arrangement according to Claim 1, characterized in that the diode (D) is a Schottky diode.

3. Circuit arrangement according to Claim 1 or 2, characterized in that the series circuit formed by a non-reactive resistor (R2) and a transistor switch (S) which is in the on state in the transmission mode is connected in parallel with the diode (D), the input of the transimpedance amplifier (TIV) being capacitively connected to the junction point (3) between non-reactive resistor (R2) and transistor switch (S).

4. Circuit arrangement according to Claim 3, characterized in that the series circuit formed by a bypass switch (T), which is controlled in opposite senses to the transistor switch, and a non-reactive resistor (R) having a resistance which is large with respect to the input resistance of the trans impedance amplifier (TIV) and small with respect to the reverse resistance of the laser diode (LD) is connected in parallel with the transistor switch (S), which is connected to a reverse-biasing potential source (U) for the laser diode (LD).

## Revendications

1. Montage pour l'inversion entre le mode de fonctionnement en émission et en réception, comprenant une diode laser (LD) fonctionnant à l'alternat, utilisée en alternance comme diode d'émission et comme diode de réception,
**caractérisé** en ce qu'en parallèle à la diode laser (LD) alimentée par un courant primaire (i_{bias}) à partir d'un circuit de régulation de point de travail (A) et par un courant de modulation (i_{mod}) à partir d'un circuit de modulation (M) , est monté un circuit série constitué d'une résistance ohmique (R1) et d'une diode (D), l'entrée d'un amplificateur transimpédance (TIV) côté réception, étant reliée de manière capacitive au point de connexion (2) entre la résistance ohmique (R1) et la diode (D).

2. Montage selon la revendication 1,
**caractérisé** en ce que la diode (D) est une diode à barrière de Schottky.

3. Montage selon la revendication 1 ou 2,
**caractérisé** en ce qu'en parallèle à la diode (D) est monté un circuit série constitué d'une résistance ohmique (R2) et d'un commutateur à transistor (S) passant en mode de fonctionnement en émission, l'entrée de l'amplificateur transimpédance (TIV) étant reliée de manière capacitive au point de connexion (3) entre la résistance ohmique (R2) et le commutateur à transistor (S).

4. Montage selon la revendication 3,
**caractérisé** en ce qu'en parallèle au commutateur à transistor (S) appliqué à une source de potentiel de blocage (U) pour la diode laser (LD), est monté un circuit série constitué d'un commutateur de shuntage (T) commandé de manière inverse au commutateur à transistor, et d'une résistance ohmique (R) présentant une valeur de résistance grande par rapport à la valeur de résistance d'entrée de l'amplificateur transimpédance (TIV) et petite par rapport la valeur de résistance de blocage de la diode laser (LD).
